(19) Europäisches Patentamt
European Patent Office
Office européen des brevets

(11) **EP 3 353 887 B1**

(12) **FASCICULE DE BREVET EUROPEEN**

(45) Date de publication et mention de la délivrance du brevet:
**29.01.2020 Bulletin 2020/05**

(21) Numéro de dépôt: **16785216.9**

(22) Date de dépôt: **23.09.2016**

(51) Int Cl.:
***H02N 2/18*** *(2006.01)*

(86) Numéro de dépôt international:
**PCT/FR2016/052416**

(87) Numéro de publication internationale:
**WO 2017/051133 (30.03.2017 Gazette 2017/13)**

(54) **SYSTEME UTILISANT UN GENERATEUR PIEZOELECTRIQUE POUR PRODUIRE UNE ENERGIE ELECTRIQUE**

SYSTEM MIT EINEM PIEZOELEKTRISCHEN GENERATOR ZUR ERZEUGUNG ELEKTRISCHER ENERGIE

SYSTEM USING A PIEZOELECTRIC GENERATOR TO PRODUCE ELECTRICAL POWER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.09.2015 FR 1559054**

(43) Date de publication de la demande:
**01.08.2018 Bulletin 2018/31**

(73) Titulaire: **Pytheas Technology**
**13590 Meyreuil (FR)**

(72) Inventeurs:
• **GROSSO, Gilles**
**83140 Six-fours (FR)**
• **MOSCA, Frédéric**
**13710 FUVEAU (FR)**

(74) Mandataire: **Roman, Alexis**
**Cabinet Roman**
**35 rue Paradis**
**B.P. 30064**
**13484 Marseille Cedex 20 (FR)**

(56) Documents cités:
DE-B1- 2 445 837    GB-A- 2 106 330
US-A1- 2005 269 907    US-A1- 2008 007 141
US-A1- 2014 252 918

## Description

### Domaine technique de l'invention.

L'invention a pour objet un système utilisant un générateur piézoélectrique pour produire une énergie électrique. Elle a également pour objet un dispositif et un procédé pour appliquer une force mécanique sur un générateur piézoélectrique afin de générer une énergie électrique.

Elle concerne le domaine technique de générateurs piézoélectriques capables de produire une énergie électrique lorsqu'ils sont soumis à une contrainte mécanique.

### État de la technique.

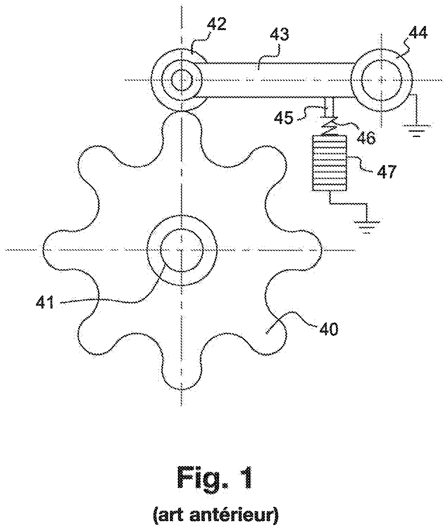

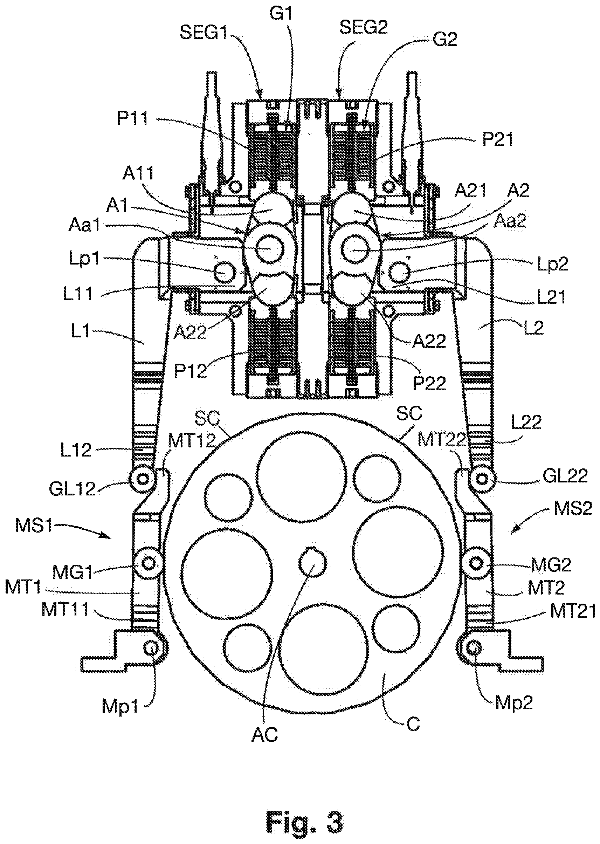

Le document brevet US 7.005.779 (ERICKSON) divulgue un système piézoélectrique permettant de produire une énergie électrique. En se référant au mode de réalisation illustré sur la figure 1 (correspondant à la figure 3 du document ERICKSON), ce système comporte un ensemble générateur comprenant :

- un générateur piézoélectrique 47 adapté pour générer une énergie électrique en réponse à une force mécanique appliquée sur ledit générateur,
- un ressort 46, jouant le rôle d'actionneur, qui applique une force mécanique sur le générateur 47 lorsque que ledit ressort est sollicité,
- une came rotative 40 présentant une surface de came,
- un galet 42 suiveur de la surface de came,
- un levier 43 relié au galet suiveur, lequel levier est monté en bras de levier et coopère avec le ressort 45 pour le solliciter lorsque la came 40 est entraînée en rotation et que la surface de came exerce une force mécanique sur le galet 42.

L'axe 41 de la came 40 est directement couplé à une source de puissance 12 qui peut être par exemple un houlogénérateur, une hydrolienne ou une éolienne, et qui met directement en rotation ladite came.

Ce système ERICKSON n'est pas très performant car la quantité d'énergie électrique qu'il peut générer est relativement faible. Le document GB2106330 divulgue un système comprenant deux générateurs piézoélectriques, deux cames et deux leviers et une roue tournante. Cependant, le document ne divulgue pas notamment les moyens suiveurs. De plus, les vitesses de rotation de la roue par rapport aux cames ne sont pas clairement divulguées.

L'invention vise à remédier à cet état des choses. En particulier, un objectif de l'invention est d'augmenter significativement la quantité d'énergie électrique capable d'être générée par un système du type décrit précédemment.

Un autre objectif de l'invention est de proposer un système générateur qui soit robuste, de conception simple, et fiable.

Encore un autre objectif de l'invention est de proposer une technique efficace pour appliquer une force mécanique sur un générateur piézoélectrique afin de générer une énergie électrique en quantité importante.

### Divulgation de l'invention.

La solution proposée par l'invention est un système pour produire une énergie électrique comportant au moins un premier ensemble générateur comprenant :

- un premier générateur piézoélectrique adapté pour générer une énergie électrique en réponse à une force mécanique appliquée sur ledit premier générateur,
- un premier actionneur adapté pour appliquer une force mécanique sur le premier générateur lorsque ledit premier actionneur est sollicité,
- une première came rotative présentant une surface de came,
- un premier moyen suiveur de la surface de came,
- un premier levier relié au premier moyen suiveur, lequel premier levier est monté en bras de levier et coopère avec le premier actionneur pour le solliciter lorsque la première came est entraînée en rotation et que la surface de came exerce une force mécanique sur le premier moyen suiveur.

Ce système comprend les caractéristiques remarquables suivantes :

- il comporte au moins un second ensemble générateur comprenant :

  ◦ un second générateur piézoélectrique adapté pour générer une énergie électrique en réponse à une force mécanique appliquée sur ledit second générateur,
  ◦ un second actionneur adapté pour appliquer une force mécanique sur le second générateur lorsque ledit second actionneur est sollicité,
  ◦ une seconde came rotative présentant une surface de came,
  ◦ un second moyen suiveur de la surface de came,
  ◦ un second levier relié au second moyen suiveur, lequel second levier est monté en bras de levier et coopère avec le second actionneur pour le solliciter lorsque la seconde came est entraînée en rotation et que la surface de came exerce une force mécanique sur le second moyen suiveur,

- une roue rotative est entraînée en rotation par une source de puissance, laquelle roue rotative est accouplée à la première came et à la seconde came de sorte que la mise en rotation de ladite roue rotative à une vitesse de rotation entraîne la rotation desdites cames à une autre vitesse de rotation qui est supérieure à celle de ladite roue rotative.

Dans cette conception particulière basée sur le principe d'un train épicycloïdal, les cames jouent le rôle de satellites et la roue rotative celui de planétaire. Une seule roue rotative permet maintenant de mettre en rotation plusieurs cames et donc de contraindre simultanément plusieurs générateurs piézoélectriques, ce qui a pour effet de démultiplier la quantité d'énergie électrique produite.

En outre, la vitesse de rotation des cames étant supérieure à celle de la roue rotative, il en résulte que la fréquence d'excitation des générateurs piézoélectriques est supérieure à la fréquence d'excitation de ladite roue rotative par la source de puissance. Cette configuration est particulièrement avantageuse dans le cas où la source de puissance se présente sous la forme d'un collecteur primaire d'énergie houlomotrice, d'une hydrolienne ou d'une éolienne, en prise directe avec l'axe de la roue rotative. L'invention permet alors de démultiplier la fréquence d'une houle ou la fréquence de rotation des pales d'une hydrolienne ou d'une éolienne, pour exciter davantage les générateurs piézoélectriques et produire davantage encore d'énergie électrique.

De manière générale, l'énergie produite pour une vitesse de rotation donnée, est déterminé par sa géométrie ainsi que par les propriétés piézoélectriques des matériaux utilisés. L'invention permet d'augmenter significativement son rendement, de manière très simple, en amplifiant sa fréquence d'excitation primaire, à savoir l'excitation de la roue rotative par la source de puissance.

D'autres caractéristiques avantageuses de l'invention sont listées ci-dessous. Chacune de ces caractéristiques peut être considérée seule ou en combinaison avec les caractéristiques remarquables définies ci-dessus, et faire l'objet, le cas échéant, d'une ou plusieurs demandes de brevet divisionnaires :

- Le système peut comporter un nombre entier N≥2 d'ensembles générateurs (EGi) comprenant chacun : - au moins un générateur piézoélectrique adapté pour générer une énergie électrique en réponse à une force mécanique appliquée sur ledit générateur ; - un actionneur adapté pour appliquer une force mécanique sur le générateur lorsque ledit actionneur est sollicité ; - une came rotative présentant une surface de came ; - un moyen suiveur de la surface de came ; - un levier relié au moyen suiveur, lequel levier est monté en bras de levier et coopère avec l'actionneur pour le solliciter lorsque la came est entraînée en rotation et que la surface de came exerce une force mécanique sur ledit moyen suiveur. La roue rotative est accouplée aux N cames de sorte que la mise en rotation de ladite roue rotative à une vitesse de rotation entraîne la rotation des N cames à une autre vitesse de rotation qui est supérieure à celle de ladite roue rotative.

- Les N cames sont avantageusement décalées angulairement par rapport à l'axe de rotation de la roue rotative, ce décalage angulaire étant de $2\pi/N$.
- Chaque ensemble générateur est avantageusement associé à une came rotative présentant une surface de came, chaque dit ensemble générateur comprenant : - un premier sous-ensemble comportant : un générateur piézoélectrique, un actionneur, un moyen suiveur de la surface de came, un levier ; - un second sous-ensemble comportant : un autre générateur piézoélectrique, un autre actionneur, un autre moyen suiveur de la surface de came, un autre levier ; le premier sous-ensemble et le second-sous-ensemble étant disposés symétriquement par rapport à l'axe de rotation de la came.
- La surface de came est avantageusement symétrique par rapport à l'axe de rotation de la came de sorte que le moyen suiveur de came du premier sous-ensemble et le moyen suiveur de came du second sous-ensemble, aient des mouvements analogues et synchronisés.
- Chaque générateur piézoélectrique se présente avantageusement sous la forme de deux piliers piézoélectriques formés chacun par l'alternance de céramiques piézoélectriques et d'électrodes empilées axialement, les deux piliers piézoélectriques étant coaxiaux et disposés en opposition l'un par rapport à l'autre.
- L'actionneur se présente avantageusement sous la forme d'une mâchoire agencée pour agir simultanément sur chacun des piliers piézoélectriques lorsqu'elle est sollicitée par le levier.
- Avantageusement, le système comporte un nombre entier M≥2 d'ensembles générateurs comprenant chacun : - au moins un générateur piézoélectrique adapté pour générer une énergie électrique en réponse à une force mécanique appliquée sur ledit générateur ; - un actionneur adapté pour appliquer une force mécanique sur le générateur lorsque ledit actionneur est sollicité ; - une came rotative présentant une surface de came ; - un moyen suiveur de la surface de came ; - un levier relié au moyen suiveur, lequel levier est monté en bras de levier et coopère avec l'actionneur pour le solliciter lorsque la came est entraînée en rotation et que la surface de came exerce une force mécanique sur ledit moyen suiveur ; les M cames sont montées en parallèle sur un arbre de rotation commun, la roue rotative étant en prise avec cet axe de rotation commun de sorte que la mise en rotation dudit axe de rotation commun entraîne la mise en rotation simultanée desdites M cames.
- Avantageusement, les M cames présentent la même surface de came, laquelle surface de came est constituée d'une alternance régulière de creux et de bosses ; et les M cames sont décalées angulairement sur l'axe de rotation commun, ce décalage angulaire étant de 2π/(M.B), où B correspond au nombre de bosses présentes sur la surface de came de chacune desdites cames.

- Dans une variante de réalisation, les M cames présentent la même surface de came, laquelle surface de came est constituée d'une alternance régulière de creux et de bosses ; et les moyens suiveurs de la surface de came de chaque ensemble générateur sont décalées angulairement sur l'axe de rotation commun, ce décalage angulaire étant de 2π/(M.B), où B correspond au nombre de bosses présentes sur la surface de came de chacune desdites cames.

- Le moyen suiveur comporte avantageusement : - une tige adaptée pour exercer une force mécanique sur le levier auquel elle est reliée, lequel levier, en réponse, sollicite l'actionneur correspondant ; - un galet, solidaire de la tige, monté roulant sur la surface de came, lequel galet est agencé de sorte que lorsque la came est entraînée en rotation et que ladite surface de came exerce une force mécanique sur ledit galet, la force mécanique exercée par ladite tige sur ledit levier soit démultipliée.

Un autre aspect de l'invention concerne un dispositif pour appliquer une force mécanique sur un générateur piézoélectrique afin de générer une énergie électrique, lequel dispositif comporte :

- un actionneur adapté pour appliquer une force mécanique sur le générateur lorsque ledit actionneur est sollicité,
- une came rotative présentant une surface de came,
- un moyen suiveur de la surface de came,
- un levier relié au moyen suiveur, lequel levier est monté en bras de levier et coopère avec l'actionneur pour le solliciter lorsque la came est entraînée en rotation et que la surface de came exerce une force mécanique sur ledit moyen suiveur.

Ce dispositif est remarquable en qu'une roue rotative est adaptée pour être entraînée en rotation par une source de puissance, laquelle roue rotative est accouplée avec la came, de sorte que la mise en rotation de ladite roue rotative à une vitesse de rotation entraîne la rotation de ladite came à une autre vitesse de rotation qui est supérieure à celle de ladite roue rotative.

Encore un autre aspect de l'invention concerne un procédé pour appliquer une force mécanique sur un générateur piézoélectrique afin de générer une énergie électrique, ledit procédé comprenant les étapes consistant à :

- installer un actionneur adapté pour appliquer une force mécanique sur le générateur (lorsque ledit actionneur est sollicité,
- installer une came rotative présentant une surface de came,
- installer un moyen suiveur de la surface de came,
- monter un levier en bras de levier,
- relier le levier au moyen suiveur, et faire coopérer ledit levier avec l'actionneur de manière à ce que ledit levier soit en mesure de solliciter ledit actionneur et qu'en réponse à cette sollicitation, ledit actionneur applique une force mécanique sur le générateur,
- entraîner la came en rotation de sorte que la surface de came exerce une force mécanique sur le moyen suiveur et que le levier sollicite l'actionneur.

Ce procédé est remarquable en ce qu'il comprend une étape consistant à accoupler la came avec une roue rotative, de sorte que la mise en rotation de ladite roue rotative à une vitesse de rotation entraîne la rotation de ladite came à une autre vitesse de rotation qui est supérieure à celle de ladite roue rotative.

**Description des figures.**

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :

- la figure 1 précitée reproduit un mode de réalisation d'un système générateur illustré dans le document brevet US 7.005.779 (ERICKSON),
- la figure 2 est une vue isométrique d'un ensemble générateur conforme à l'invention,
- la figure 3 est une vue en coupe longitudinale de l'ensemble générateur de la figure 2,
- la figure 4 est une vue schématique, en coupe, d'un pilier piézoélectrique utilisé dans un générateur piézoélectrique conforme à l'invention,
- la figure 5 est une vue schématique du pilier piézoélectrique de la figure 4 combiné à un circuit d'extraction de charge,
- la figure 6 est un schéma cinématique montrant un agencement des différents éléments constitutifs d'un ensemble générateur conforme à l'invention,
- la figure 7 schématise deux ensembles générateurs conformes à l'invention, lesquels ensembles sont combinés à une roue rotative commune,
- la figure 8 est une vue isométrique du système objet de l'invention, montrant en détail un exemple de coopération entre les cames et la roue rotative commune,
- la figure 9 est une vue de face d'un système objet de l'invention,
- la figure 10 est une vue en élévation du système de la figure 9,
- la figure 11 montre le système de la figure 10 fermée par un carter,
- la figure 12 montre un ensemble générateur conforme à l'invention, dans une variante de réalisation.

## Modes préférés de réalisation de l'invention.

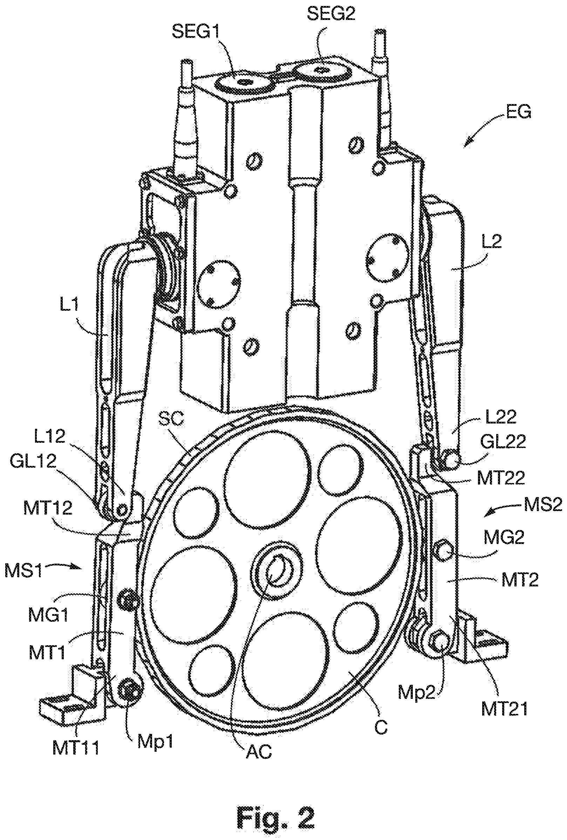

Les figures 2 et 3 illustrent un ensemble générateur EG adapté à la mise en œuvre de l'invention. Cet ensemble générateur EG est associé à une came rotative C présentant une surface de came SG.

La came C est montée rotative autour de son axe de symétrie Ac. La came C se présente par exemple sous la forme d'un disque métallique dont le diamètre est compris entre 0,5 cm et 300 cm, préférentiellement 40 cm et son épaisseur comprise entre 2 mm et 100 mm.

Sur les figures 2 et 3, la surface de came SC est ondulée. Elle est constituée d'une alternance régulière de creux et de bosses répartis de manière homogène sur toute la périphérie de la came C. L'amplitude des creux et des bosses est par exemple comprise entre 1 mm et 50 mm, préférentiellement de 2 mm. La surface de came SC présente avantageusement un profil sinusoïdal. La répartition des creux et des bosses est parfaitement symétrique de sorte que deux bosses ou deux creux soient situés aux extrémités d'un même diamètre de la came C.

L'ensemble générateur EG illustré sur les figures 2 et 3 comprend deux sous-ensembles générateurs SEG1, SEG2.

Le premier sous-ensemble SEG1 comportant un générateur piézoélectrique G1, un actionneur A1, un moyen MS1 suiveur de la surface de came SC et un levier L1. Le second sous-ensemble SEG2 est similaire au premier et comporte également un générateur piézoélectrique G2, un actionneur A2, un moyen MS2 suiveur de la surface de came SC et un levier L2.

Chaque générateur piézoélectrique G1, G2 se présente préférentiellement sous la forme de deux piliers piézoélectriques respectivement P11, P12 et P21, P22 formés chacun par l'alternance de céramiques piézoélectriques et d'électrodes empilées axialement, les deux piliers piézoélectriques, respectivement P11-P12 et P21-P22, étant coaxiaux et disposés en opposition l'un par rapport à l'autre.

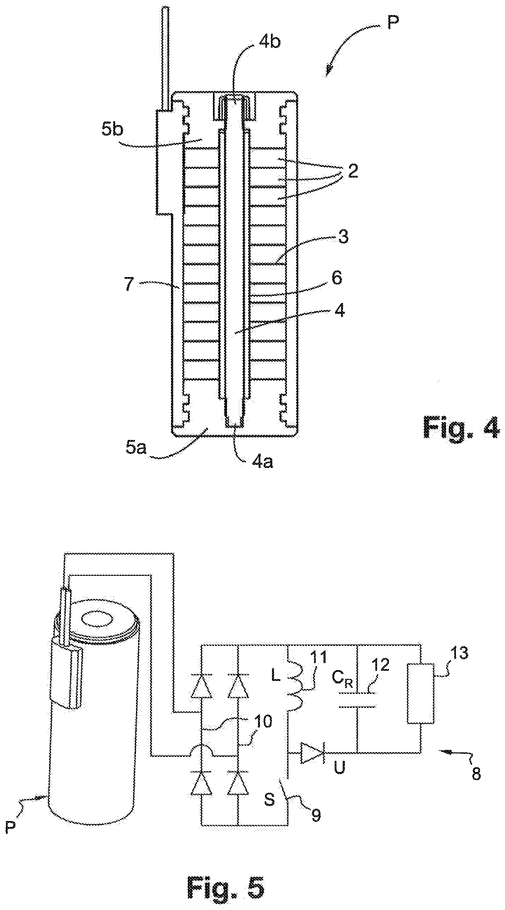

Les piliers P11, P12 et P21, P22 sont identiques. La figure 4 représente un de ces piliers, lequel pilier porte la référence P. Il se compose d'un empilement de céramiques piézoélectriques 2 alternées avec des électrodes 3 fabriquées dans un matériau conducteur, comme par exemple le cuivre ou le bronze. Les électrodes sont câblées en parallèles ou en série. Le nombre de céramiques 2 et d'électrodes 3 varie de 2 à 50, voire 150. Ces céramiques 2 et électrodes 3 ont la même forme et ont préférentiellement une section circulaire. Elles sont percées axialement. A titre d'exemple, leur diamètre externe est compris entre 0,5 cm et 20 cm, et leur épaisseur comprise entre 1 mm et 100 mm. Le diamètre du perçage axial est par exemple compris entre 0,5 cm et 10 cm. Les perçages axiaux assurent un alignement axial des céramiques 2 et des électrodes 3.

Lorsque les céramiques 2 et les électrodes 3 sont empilées, les perçages axiaux délimitent un alésage central coaxial à l'axe du pilier P. Cet alésage central permet le passage d'une tige 4 qui assure le centrage, l'alignement et participe au maintien des céramiques 2 et des électrodes 3. Des moyens de fixation 5a, 5b sont disposés aux extrémités 4a, 4b de la tige 4. Ces moyens de fixation 5a, 5b se présentent par exemple sous la forme de pièces rigides fixées aux extrémités 4a, 4b de la tige 4 de manière à venir enserrer l'empilement des céramiques 2 et des électrodes 3. La pièce 5a se présente par exemple sous la forme d'un écrou vissé à l'extrémité filetée 4a de la tige 4. La pièce 5b peut également être un écrou, ou une pièce taraudée, fixée à un châssis, et dans laquelle se visse l'autre extrémité filetée 4b de la tige 4.

Pour des raisons de sécurité, l'empilement des céramiques 2 et des électrodes 3 est avantageusement isolé électriquement. Pour ce faire, la tige 4 peut être placée dans un fourreau ou gaine 6 fabriquée dans un matériau isolant électrique tel qu'un plastique. On peut également prévoir de loger l'empilement dans un fourreau ou dans une gaine extérieure 7 également fabriquée dans un matériau isolant électrique.

Comme le montre la figure 5, le pilier P est raccordé à un circuit électronique 8 d'extraction de charges. Ce circuit 8 récupère l'énergie électrique produite par le pilier piézoélectrique P. Il comprend :

- un interrupteur haute tension à commande 9, avantageusement un thyristor,
- un pont redresseur de tension 10,
- une inductance 11 dont le raccordement avec le pilier P constitue un circuit résonnant du type LC, l'élément capacitif étant constitué par le pilier lui-même,
- une capacité ou un condensateur de filtrage 12 mis en parallèle.
- un système de stockage 13 permet de stoker cette énergie électrique avant son conditionnement pour une utilisation sur le réseau. Ce système de stockage 13 consiste par exemple en une batterie ou un banc de super-capacités. Le circuit 8 peut être commun à chaque paire de piliers respectivement P11-P12 et P21-P22, en étant connecté simultanément à chacun des piliers de ladite paire. Un bus continu peut alors être chargé de collecter les impulsions de chacun des systèmes de stockage 13.

La configuration du circuit 8 est adaptée pour maximiser l'énergie électrique produite par le pilier P. Cette configuration permet en effet de doubler l'énergie électrique générée par le pilier P en la récupérant une première fois lors de l'écrasement dudit pilier, et une seconde fois lors de son relâchement.

Lorsque le pilier P est soumis à une excitation alternative (selon le principe décrit plus avant dans la description), et durant la phase croissante de la contrainte, l'interrupteur 9 est maintenu ouvert. Le pilier P est en circuit ouvert et les charges électriques s'accumulent aux bornes dudit pilier, ce dernier fonctionnant comme une capacité.

Lorsque la contrainte mécanique appliquée au pilier P est maximale, l'interrupteur 9 est brièvement fermé pendant une durée correspondant à une demi-période de la résonance du circuit LC. Ainsi, l'ensemble des charges électriques accumulées aux bornes du pilier P sont extraites dudit pilier.

Durant la phase décroissante de la contrainte, le pilier P se recharge. Lorsque la contrainte mécanique est minimale, l'interrupteur 9 est de nouveau brièvement fermé pendant une durée correspondant à une demi-période de la résonance du circuit LC, de manière à extraire les charges électriques. Puis le cycle reprend.

Pour produire une énergie électrique, il est nécessaire d'appliquer une force mécanique sur les piliers piézoélectriques P11, P12, P21, P22. Cette force mécanique est appliquée par les actionneurs A1 et A2.

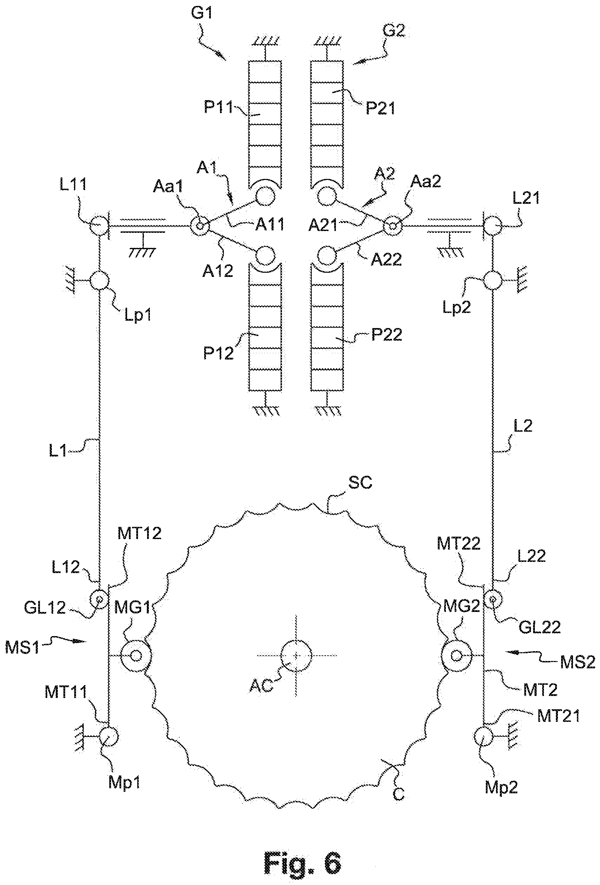

Dans le mode préféré de réalisation illustré sur les figures 3 et 6, chaque actionneur, respectivement A1 et A2, agit sur une paire de piliers, respectivement P11-P12 et P21-P22. Chaque actionneur, respectivement A1 et A2, se présente sous la forme d'une mâchoire agencée pour agir simultanément sur chacun des piliers piézoélectriques, respectivement P11-P12 et P21-P22, lorsqu'elle est sollicitée par le levier, respectivement L1 et L2.

Plus particulièrement, chaque mâchoire est constituée de deux poussoirs, respectivement A11-A12, A21-A22, montés sur un axe commun, ou articulation, respectivement Aa1, Aa2, ou deux axes adjacents. Ces poussoirs, respectivement A11, A12, A21 et A22, sont en appui contre une des extrémités des piliers, respectivement P11, P12, P21 et P22, lequel appui peut se concevoir sous la forme d'une liaison rotule. Chaque articulation Aa1, Aa2 est aménagée de manière qu'une poussée sur ladite articulation, force les poussoirs A11- A12, A21-A22 à s'écarter et appuyer sur l'extrémité des piliers avec lesquels ils sont en contact. L'autre extrémité des piliers étant solidaire d'un bâti fixe, les piliers P11, P12, P21 et P22 sont écrasés, lequel écrasement engendre une déformation desdits piliers et la production d'énergie électrique.

Sur les figures annexées, chaque générateur G1, G2 comprend deux piliers, respectivement P11-P12 et P21-P22, qui sont coaxiaux et disposés en opposition. Dans cette configuration, chaque poussoir A11, A12, A21, A22 exerce sur le pilier auquel il est rattaché, une force d'écrasement supérieure à la force de poussée appliquée sur les articulations Aa1, Aa2. Cette amplification de force (d'un facteur pouvant varier de 2 à 100) est due à l'angle d'ouverture des poussoirs A11-A12 et A21-A22 et est similaire à l'amplification de forces dans un parallélogramme déformable. L'utilisation de ce type de mâchoire entre chaque paire de piliers P11-P12 et P21-P22, permet en outre de réduire de moitié la hauteur de piliers P11, P12, P21, P22 et de réduire de moitié les contraintes sur le bâti.

Chaque levier, respectivement L1, L2, est monté en bras de levier et coopère avec l'actionneur auquel il est associé, respectivement A1, A2, pour le solliciter. Sur la figure 6, les leviers L1, L2 exercent la force de poussée sur les axes Aa1, Aa2. Par « *monté en bras de levier* », on entend au sens de la présente invention que chaque levier L1, L2 est monté mobile en rotation autour d'un point fixe ou d'une liaison pivot Lp1, Lp2. Ces leviers comprennent une première extrémité L11, L21 qui coopère avec l'actionneur A1, A2 auxquels lesdits leviers sont associés, et une seconde extrémité L21, L22 reliée à un moyen suiveur MS1, MS2. Pour amplifier la force de poussée exercée sur les axes Aa1, Aa2, les points de rotation Lp1, Lp2 sont plus près des premières extrémités L11, L21 que de la seconde extrémité L12, L22. Chaque levier L1, L2 se présente préférentiellement sous la forme d'une pièce rigide en métal obtenue par moulage ou usinage et dont la longueur est par exemple comprise entre 10 cm et 100 cm.

Les moyens suiveurs MS1, MS2 sont adaptés pour solliciter les leviers L1, L2, et les faire pivoter autour de leurs points de rotation Lp1, Lp2, lorsque la came C est entraînée en rotation.

Sur les figures 2, 3 et 6, chaque moyen suiveur MS1, MS2 comporte une tige MT1, MT2 adaptée pour exercer une force mécanique sur le levier L1, L2 auquel elle est reliée et qui, en réponse, sollicite l'actionneur correspondant A1, A2. Les tiges MT1, MT2 sont chacune montée mobile en rotation autour d'une liaison pivot Mp1, Mp2 aménagée au niveau d'une première extrémité MT11, MT21. Leur seconde extrémité MT12, MT22 est en appui contre la seconde extrémité L12, L22 des leviers L1, L2. Pour limiter les frottements, les secondes extrémités L12, L22 peuvent être chacune pourvue d'un galet rotatif GL12, GL22.

Les tiges MT1, MT2 se présentent préférentiellement chacune sous la forme d'une pièce rigide en métal obtenue par moulage ou usinage et dont la longueur est par exemple comprise entre 5 cm et 50 cm.

Chaque tige MT1, MT2 est solidaire d'un galet MG1, MG2 qui est monté roulant sur la surface de came MC. Ces galets MG1, MG2 sont agencés entre les deux extrémités des tiges MT1, MT2, de sorte que lorsque la came C est entraînée en rotation et que la surface de came SC exerce une force mécanique sur ledit galet, la force mécanique exercée par les tiges MT1, MT2 sur les leviers L1, L2 soit démultipliée.

En pratique, lorsque les galets MG1, MG2 passent sur une bosse, ils s'écartent de l'axe de rotation de la came AC. Cet écartement des galets MG1, MG2 entraîne le pivotement des tiges MT1, MT2 autour de leur première extrémité MT11, MT12. Les leviers L1, L2 sont alors sollicités au niveau de leur seconde extrémité L12, L22, entraînant leur pivotement autour des points de rotation Lp1, Lp2, lequel pivotement génère une force de poussée sur les axes Aa1, Aa2.

Ce type de moyen suiveur présente de nombreux avantages. En effet, si H est la hauteur des bosses, la seconde extrémité MT12, MT22 des tiges MT1, MT2 se déplace de Y.H avec Y≥1 et dont la valeur dépend de la position des galets MG1, MG2 sur lesdites tiges. Le débattement de la seconde extrémité L12, L22 des leviers L1, L2 est également de YxH. En amplifiant le débattement des secondes extrémités L12, L22 des leviers L1, L2, les moyens suiveurs MS1, MS2 démultiplient ainsi les forces de poussée exercées sur les axes Aa1, Aa2, et donc les forces mécaniques exercées sur les piliers P11, P12, P21, P22, et de fait l'énergie électrique produite.

La hauteur des bosses est déterminée en fonction de l'effort d'écrasement voulu sur les piliers P11, P12, P21, P22. Etant donné que le débattement des secondes extrémités L12, L22 des leviers L1, L2 est amplifié, il est envisageable de réduire la hauteur des bosses de la surface de came SC, par rapport à la configuration illustrée sur la figure 1 (où le moyen suiveur est un galet 42 directement fixé sur la seconde extrémité du levier 43). Cette diminution de la hauteur des bosses permet de faire tourner la came C plus vite, et d'augmenter par conséquent la fréquence de sollicitation des actionneurs A1, A2 et donc celle des piliers P11, P12, P21, P22. Ces derniers étant davantage sollicités, l'énergie électrique qu'ils génèrent l'est également, ce qui contribue à augmenter le rendement du système objet de l'invention.

Il est également envisageable d'augmenter la hauteur des bosses de la surface de came SC pour amplifier encore davantage le débattement des secondes extrémités L12, L22 des leviers L1, L2 et augmenter proportionnellement les forces mécaniques exercées sur les piliers P11, P12, P21, P22. La taille de ces derniers peut ainsi être augmentée pour produire davantage d"énergie électrique.

Le nombre B de bosses présentes sur la surface de came SC participe au pompage fréquentiel de l'excitation des générateurs piézoélectriques. Ce nombre permet d'amplifier la fréquence d'excitation des piliers P11, P12, P21, P22. En effet, pour chaque tour de came C, chacun des piliers P11, P12, P21, P22 est excité B fois. A titre d'exemple seulement, on peut prévoir une surface de came présentant 24 bosses de 2 mm de hauteur, espacées de 50 mm pour une came C ayant un diamètre de 40 cm. On privilégie une came C ayant un nombre paire de bosses et de générateurs piézoélectriques G1, G2 en vis-à-vis afin d'annuler les efforts radiaux engendrés par les galets MG1, MG2 sur ladite came.

Dans le mode de réalisation illustré par les figures annexées, le premier sous-ensemble SEG1 et le second-sous-ensemble SEG2 sont disposés symétriquement par rapport à l'axe de rotation AC de la came C. Et préférentiellement, la surface de came SC est symétrique par rapport à l'axe de rotation AC de la came C de sorte que le moyen suiveur MS1 du premier sous-ensemble SEG1 et le moyen suiveur MS2 du second sous-ensemble SEG2, aient des mouvements analogues, synchronisés et diamétralement opposés. En pratique, les deux moyens suiveurs MS1 et MS2 agissent sur un même diamètre de la came C. Lorsque le moyen suiveur MS1 passe sur une bosse (respectivement un creux) de la surface de came SC, l'autre moyen suiveur MS2 passe également sur une bosse (respectivement un creux). Cette architecture permet d'équilibrer les sollicitations de la came C de sorte que cette dernière est moins sujette aux vibrations.

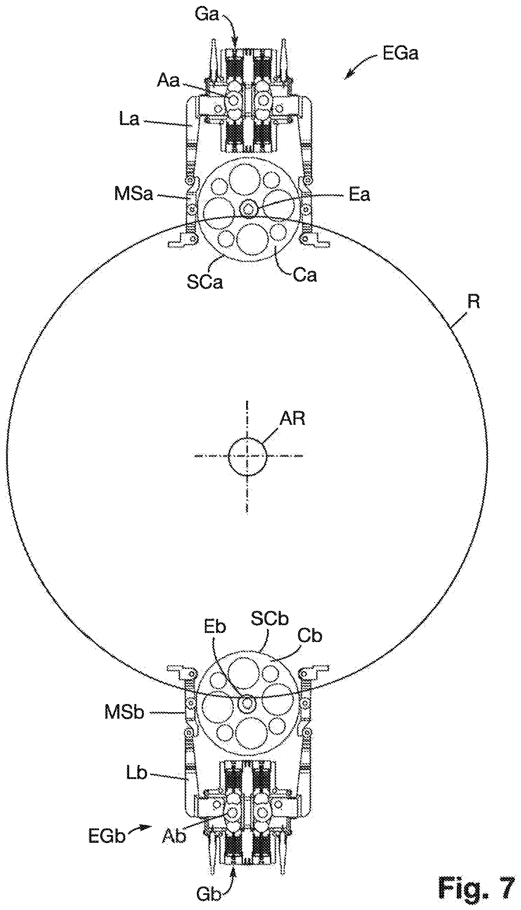

Sur la figure 7, deux ensembles générateurs EGa, EGb sont représentés. Chacun de ces ensembles générateurs EGa, EGb est similaire à l'ensemble générateur EG qui vient d'être décrit en référence aux figures 2 à 6, c'est-à-dire que chaque ensemble EGa, EGb comprend au moins un générateur piézoélectrique Ga, Gb auquel est associé un actionneur Aa, Ab, une came rotative Ca, Cb présentant une surface de came SCa, SCb, un moyen suiveur MSa, MSb, un levier La, Lb.

La mise en rotation des cames Ca et Cb est réalisée de manière simultanée grâce à une roue rotative commune R. Cette dernière est montée mobile en rotation autour de son axe AR. Son diamètre est par exemple compris entre 10 cm et 800 cm.

La roue R peut par exemple comporter un engrenage aménagé sur sa périphérie, lequel engrenage est en prise avec un engrenage complémentaire Ea, Eb solidaire de l'axe de rotation respectif des cames Ca, Cb. La roue R et les engrenages Ea, Eb sont dimensionnés de sorte que la mise en rotation de ladite roue à une vitesse de rotation $W_R$ entraîne la rotation des cames Ca, Cb à une autre vitesse de rotation $W_{Ca}$, $W_{Cb}$ qui est supérieure à celle de ladite roue.
En pratique

$$\text{En pratique } W_{Ca} = W_{Cb} = W_R \times Z_R/Z_C \text{ où :}$$

$Z_R$ = nombre de dents de la roue R
Zc = nombre de dents des engrenages Ea, Eb
avec $Z_R > Z_C$

Une source de puissance assure l'entraînement en rotation de la roue R. Cette source de puissance peut être une éolienne ou une hydrolienne dont l'axe coïncide avec l'axe AR. La source de puissance peut également être un houlogénérateur mise en rotation par la houle de la mer, ou toute autre source motrice adaptée pour mettre en rotation la roue R (ex : moteur thermique, moteur électrique, moteur à air comprimé .....).

Dans le cas où la source de puissance est une éolienne, une hydrolienne ou un houlogénérateur, la vitesse de rotation à laquelle est susceptible d'être entraînée la roue R est relativement faible, par exemple de quelques tours par minute mais avec un couple relativement important, pouvant être de plusieurs centaines voire milliers de kN.m. Grâce à l'invention, la vitesse de rotation des cames Ca, Cb est nettement supérieure, pouvant atteindre plusieurs centaines de tours par minute avec un couple suffisant pour contraindre les générateurs piézoélectriques Ga, Ga à une fréquence d'excitation décuplée par rapport à la fréquence d'excitation de la roue R. Cet état de choses contribuant à produire une quantité importante d'énergie électrique, par exemple plusieurs centaines de kW, voire plusieurs Méga W.

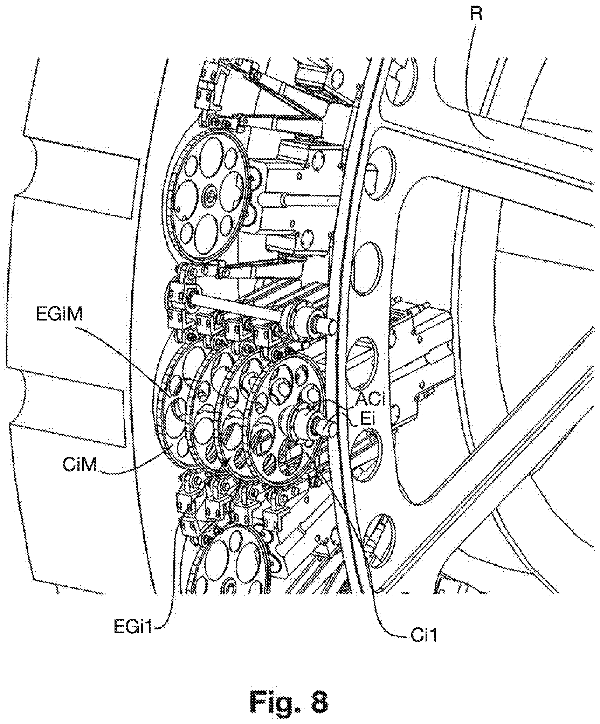

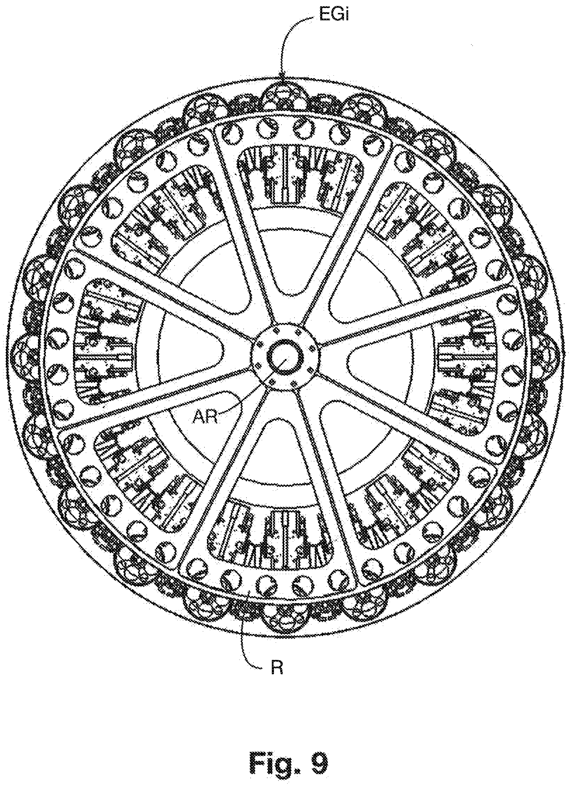

Sur les figures 8, 9 et 10, le système objet de l'invention comporte un nombre N d'ensembles générateurs EGi, où N est un entier supérieur ou égal à 2. Cette architecture est basée sur le principe d'un train épicycloïdale, les N cames jouant le rôle de satellites et la roue R celui de planétaire. Il suffit donc de mettre en rotation la seule roue R pour entraîner en rotation les N cames et contraindre simultanément plusieurs générateurs piézoélectriques, ce qui a pour effet de démultiplier la quantité d'énergie électrique produite. Dans le cas où chaque came est combinée à deux générateurs piézoélectrique (cas des figures 2 à 7), la mise en rotation la roue R permet de contraindre simultanément 2xN générateurs piézoélectriques.

Le fait de passer par une architecture du type train épicycloïdal, permet d'éliminer une éventuelle la boîte de transmission qui permettrait l'augmentation de la vitesse de rotation des cames. Dans le cas d'une boîte de transmission, le couple venant de la source de puissance passe par un seul chemin pour arriver aux cames. C'est un point faible des éoliennes sur lesquelles on constate de nombreuses avaries. Grâce à l'architecture de l'invention, le couple venant de la source de puissance est divisé par le nombre de cames-satellites, ce qui rend le système beaucoup plus fiable.

Chacun de ces ensembles générateurs EGi est similaire à l'ensemble générateur EG décrit en référence aux figures 2 à 6, c'est-à-dire qu'il comprend : un générateur piézoélectrique, un actionneur, une came rotative présentant une surface de came, un moyen suiveur de la surface de came, un levier. La roue R est accouplée aux N cames de sorte que la mise en rotation de ladite roue rotative à une vitesse de rotation entraîne la rotation des N cames à une autre vitesse de rotation qui est supérieure à celle de ladite roue rotative. L'accouplement entre la roue R et les N cames est réalisé de la même façon que décrite précédemment en référence à la figure 7.

Pour homogénéiser la répartition du couple au niveau de la roue R et équilibrer les contraintes sur cette dernière, les N cames sont décalées angulairement de $2\pi/N$ par rapport à l'axe de rotation AR de la roue R.

Dans le mode de réalisation de la figure 8, un nombre M d'ensembles générateurs $EGi_1$-$EGi_M$ sont empilés axialement les un derrière les autres, où M est un entier supérieur ou égal à 2. Chacun de ces ensembles générateurs $EGi_1$-$EGi_M$ est similaire aux ensembles générateurs EG, EGa, EGb décrits précédemment en référence aux figures 2 à 7, c'est-à-dire qu'ils comprennent chacun : au moins un générateur piézoélectrique auquel est associé un actionneur, une came rotative $Ci_1$-$Ci_M$ présentant une surface de came, un moyen suiveur, un levier.

Les M cames $Ci_1$-$Ci_M$ sont montées en parallèle sur un arbre de rotation commun ACi qui coïncide avec leur axe de rotation respectif. Le maintien en position des cames $Ci_1$-$Ci_M$ sur l'arbre ACi est par exemple, assuré par clavetage. L'extrémité de l'arbre ACi qui est située au niveau de la roue R est pourvue d'un engrenage Ei en prise avec l'engrenage complémentaire aménagé sur la périphérie de ladite roue. Ainsi, lorsque la roue R est mise en rotation, son engrenage périphérique engrène l'engrenage Ei, provoquant l'entraînement en rotation de l'arbre ACi et de l'ensemble des cames $Ci_1$-$Ci_M$.

Préférentiellement, les cames $Ci_1$-$Ci_M$ présentent la même surface de came mais sont décalées angulairement les unes par rapport aux autres, ce décalage angulaire étant de $2\pi/(M.B)$, où :

M = nombre entier supérieur ou égal à 2 (par exemple compris entre 2 et 20) correspondant au nombre de cames $Ci_1$-$Ci_M$ solidaires de l'arbre ACi ;
B = nombre de bosses présentes sur la surface de came de chacune desdites cames $Ci_1$-$Ci_M$.

Ce décalage angulaire des cames $Ci_1$-$Ci_M$ présente plusieurs avantages. Tout d'abord, il permet de compenser les efforts tangentiels appliqués sur les moyens suiveurs et notamment sur leur galet de roulement. Cet effort tangentiel correspond à l'effort que doit surmonter le galet pour remonter une bosse de la surface de came. Cet effort tangentiel induit un couple résistant sur l'arbre ACi. Grâce au décalage angulaire des cames $Ci_1$-$Ci_M$, lorsqu'un galet d'une première came va remonter une bosse et créer un couple résistant, un galet d'une autre came va simultanément descendre une bosse. L'effort tangentiel appliqué sur cette autre came, et qui résulte de la descente du galet correspondant, induit un couple moteur sur l'arbre ACi qui annule le couple résistant précité. Ainsi, tous les efforts tangentiels induits par des galets « montants » sont compensés par les efforts tangentiels induits par des galets « descendants ».

De plus, lorsque les piliers piézoélectriques sont sollicités par les actionneurs, leur effort de réaction est principalement constitué de deux composantes : - un effort de raideur dit « élastique », proportionnel au module d'élasticité de l'empilement des céramiques piézoélectriques et des électrodes, via la loi de Hook ; - et un effort de raideur dit « électrique » dû au comportement diélectrique des céramiques piézoélectriques. Ces efforts de réaction se répercutent sur les efforts tangentiels appliqués sur les moyens suiveurs et notamment sur leur galet de roulement.

Chaque paire de piliers piézoélectriques génère donc un couple tangentiel sinusoïdal dû à son élasticité. En déphasant les cames $Ci_1$-$Ci_M$, et donc les paires de générateurs, le couple tangentiel résultant de la somme des couples tangentiels sinusoïdaux, est annulé en entrée du système, c'est-à-dire au niveau de l'axe AR de la roue R.

L'extraction de charge (dû à la fermeture des interrupteurs 9 aux sommets des bosse et aux creux des cames) génère un couple tangentiel de type Coulomb, c'est à dire d'amplitude constante et de signe opposée à la vitesse de rotation des cames $Ci_1$-$Ci_M$. Ces couples de Coulomb s'ajoutent et génèrent un couple de Coulomb constant au niveau de l'axe AR de la roue R. L'entrée du système, c'est-à-dire l'axe AR de la roue R, n'est donc soumis qu'à un couple de Coulomb.

Si les interrupteurs 9 ne sont pas actionnés, alors ce couple de Coulomb est nul aux frottements près, mais on ne peut pas extraire d'énergie électrique du système.

Si tous les interrupteurs 9 sont actionnés simultanément, alors ce couple de Coulomb est maximal sur l'axe AR et s'oppose au couple réactif, ce qui contribue à diminuer la puissance électrique susceptible d'être récupérée par le système.

En actionnant une partie seulement des interrupteurs 9 à un instant donné, il est possible d'ajuster le couple de Coulomb sur l'axe AR pour ajuster le couple réactif à une valeur permettant une récupération de puissance électrique optimale.

Lors de la fermeture des interrupteurs 9 (figure 5), au moment où les galets des moyens suiveurs atteignent le sommet d'une bosse ou le fond d'un creux, l'effort de raideur « électrique » devient nul. L'effort de réaction des piliers concernés est alors déséquilibré par rapport aux efforts de réaction des autres piliers dont les interrupteurs associés restent ouverts. Ce déséquilibre est susceptible d'impacter les efforts tangentiels appliqués sur les cames $Ci_1$-$Ci_M$ et de créer un couple résistant, ou couple de Coulomb, sur l'arbre ACi. La demanderesse a constaté de manière surprenante que le décalage angulaire des cames $Ci_1$-$Ci_M$ permet de réduire, voire annuler ce couple de Coulomb.

Lorsqu'un galet d'un moyen suiveur est en creux de came, et que l'interrupteur 9 associé est fermé pour l'extraction de charge, ledit galet est en contact avec le profil de came et les piliers piézoélectriques sont relaxés.

Lorsque ce galet remonte au sommet d'une bosse, le pilier piézoélectriques est chargé et sous contrainte. Sa charge est extraite en fermant l'interrupteur 9. Le pilier voit sa contrainte diminuée, sans que celle-ci ne soit annulée.

Lorsque le galet redescend dans le creux, le pilier piézoélectriques est relaxé mais chargé. La longueur reste inférieure à la longueur de départ et on peut observer un décollement du galet du profil de came.

Quand enfin la charge est extraite en fermant l'interrupteur 9, le pilier piézoélectrique reprend soudainement sa forme initiale et on observe un choc entre ledit galet et le profil de came. Par transfert de contrainte, ce choc peut endommager les éléments constitutifs du pilier piézoélectrique qui seraient décollés, et particulièrement les céramiques 2 qui sont de nature fragile. Pour remédier à cela, on précontraint les piliers piézoélectriques pour qu'il n'y ait jamais décollement, par exemple à 150 Bars.

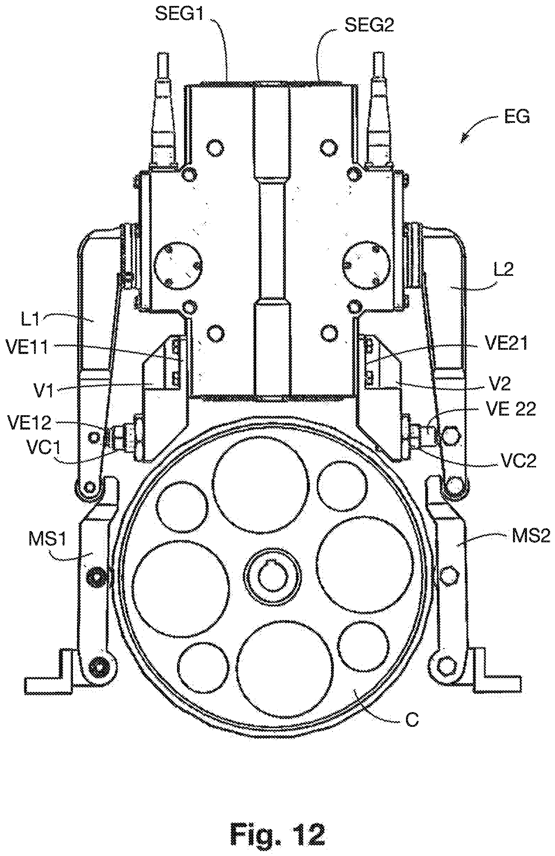

Sur la figure 12, cette précontrainte est induite par deux vérins V1, V2 à ressort, par exemple du type rondelle élastique Belleville ou à boudin. Ces vérins V1, V2 sont installés avant la mise en place des moyens suiveurs MS1, MS2. Ils sont placés dans la même symétrie que les sous-ensembles SEG1 et SEG2. Les vérins V1, V2 ont une extrémité VE11, VE21 fixée sur le bâti des sous-ensembles SEG1, SEG2, l'autre extrémité VE12, VE22, formant butée venant pousser le levier L1, L2 à la force désirée. Cette force peut être régler par l'intermédiaire d'un écrou VC1, VC2 qui vient comprimer/détendre le ressort. A titre d'exemple, la précontrainte appliquée sur les piliers piézoélectriques est de 150 Bars. A l'endroit où est appliqué la précontrainte, l'effort sur le levier L1, L2 est approximativement de 100 daN pour un déplacement dudit levier de 1,4 mm. Le ressort à une course de 14 mm quand on lui applique les 100 daN. Cette marge permet d'éviter tout décollement de la butée VE12, VE22 et aussi d'appliquer un effort conséquent quand les galets des moyens suiveurs MS1, MS2 commencent leur montée sur une bosse de la came C.

Un résultat similaire est obtenu en décalant de la même manière, non pas les M cames $Ci_1$-$Ci_M$, mais les moyens suiveurs de la surface de came de chaque ensemble générateur $EGi_1$-$EGi_M$.

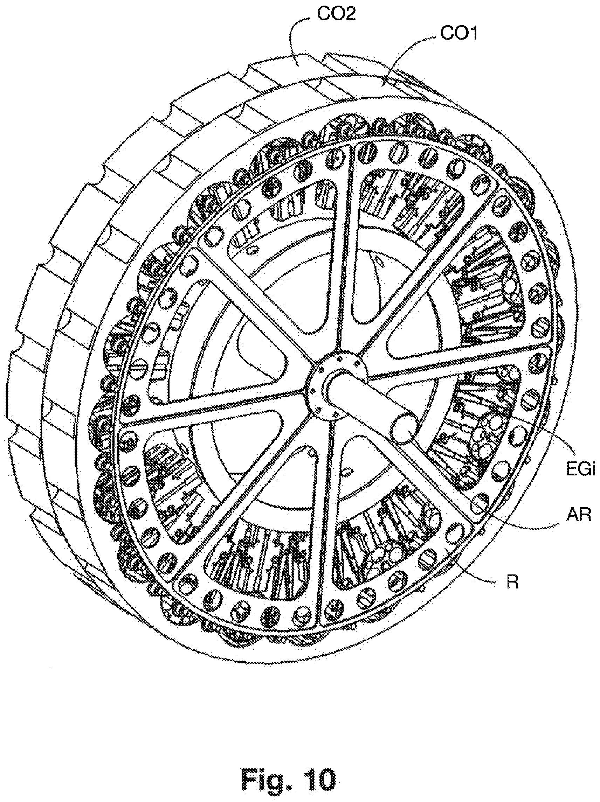

L'ensemble constitué par une roue rotative R combinée à plusieurs cames peut être défini comme une couronne motrice. Sur la figure 10, deux couronnes motrices CO1, CO2 sont accolées l'une à l'autre.

La roue R de chaque couronne peut être solidaire d'un arbre commun AR de sorte que la rotation de ce dernier entraîne la rotation desdites roues. La quantité d'énergie électrique produite est ainsi doublée. Dans cette architecture, c'est l'arbre commun AR qui est entraîné en rotation par la source de puissance externe.

Dans une variante de réalisation, on prévoit une seule roue rotative R. Les deux couronnes motrices CO1, CO2 sont placées en quinconce. Les arbres entrainant les cames de chaque couronne sont décalés de manière à venir s'engrener sur la roue rotative commune R, ce qui double le nombre de cames-satellites associés à ladite roue.

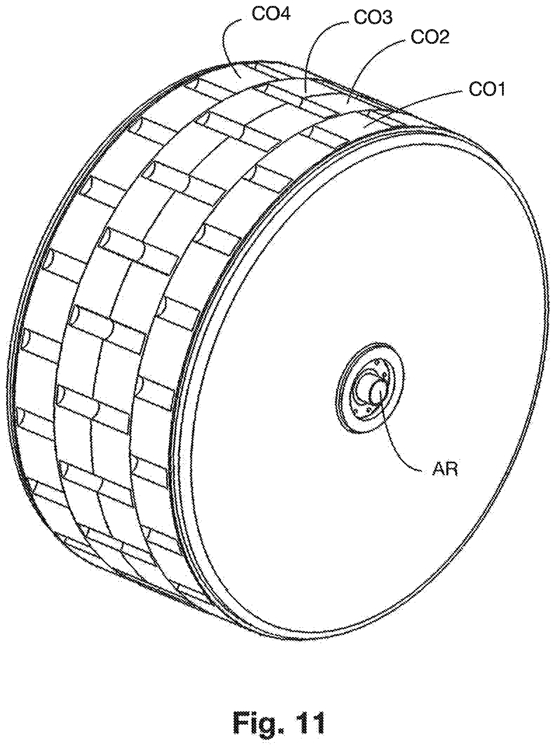

Sur la figure 11, quatre couronnes motrices CO1, CO2, CO3, CO4 sont juxtaposées côte-à-côte. L'ensemble est protégé et isolé par un carénage. Chaque paire de couronnes motrices CO1-CO2 et CO3-CO4 est associée à sa propre roue rotative R. Ces deux roues rotatives sont solidaires d'un arbre commun AR de sorte que la rotation de ce dernier entraîne la rotation desdites roues.

L'agencement des différents éléments et/ou moyens et/ou étapes de l'invention, dans les modes de réalisation décrits ci-dessus, ne doit pas être compris comme exigeant un tel agencement dans toutes les implémentations. En tout état de cause, on comprendra que diverses modifications peuvent être apportées à ces éléments et/ou moyens et/ou étapes. En particulier :

- le nombre d'ensembles générateurs et/ou leur conception et/ou dimensionnement, peuvent varier selon le rendement énergétique désiré pour le système ;
- la surface de came SC peut présenter un profil sinusoïdal, mais avec un méplat au sommet des bosses et au fond des creux, ce profil permettant d'optimiser l'extraction des charges électriques accumulées aux bornes du pilier P,
- l'ensemble générateur EG peut comporter un seul sous-ensemble SEG1 ou SEG2 en prise avec la came C,
- l'ensemble générateur EG peut au contraire comporter plus de deux sous-ensembles répartis de manière homogène autour de la came C (par exemple un nombre X de sous-ensembles décalés de $2\pi/X$, où X est un entier supérieur à 2, notamment compris entre 2 et 20) ; on peut envisager une configuration permettant de distribuer l'effort de façon à ce qu'il ne soit pas appliqué sur tous les moyens suiveurs en même temps : pour un temps donné, certains moyens suiveurs se déplacent sur des bosses pendant que d'autres se déplacent dans des creux ; pour cela, la came comporte préférentiellement aX+1 bosses, le paramètre a étant un nombre entier, préférentiellement égal à 2, choisi pour que le nombre de bosses soit supérieur au nombre de moyens suiveurs ; avec un tel nombre de bosses, les efforts tangentiels exercés par les moyens suiveurs sur la came se compensent pour réduire l'effort tangentiel global résultant ; un nombre de bosses différent peut toutefois être envisagé : on peut par exemple envisager un nombre de bosses égal à un multiple du nombre de moyens suiveurs avec, dans ce cas particulier, un effort tangentiel résultant qui est égal à la somme des efforts tangentiels des moyens suiveurs ;
- l'ensemble générateur EG peut comporter un nombre impair de sous-ensembles équirépartis autour de la came C,
- les ensembles générateurs EG, Ega, EGb, EG1 peuvent être situés à l'extérieur du périmètre de la roue rotative R (figures 7 à 10), ou à l'intérieur de ce périmètre,
- chaque générateur piézoélectrique G1, G2 peut comprendre un seul pilier piézoélectrique, ou au contraire plusieurs autres piliers piézoélectriques dont le nombre peut par exemple être compris entre 3 et 40 ;
- les céramiques 2 et les électrodes 3 peuvent avoir une section carrée, rectangulaire, ovale, etc ; ces éléments 2, 3 peuvent également présenter d'autres aménagements équivalents à leur perçage axial pour assurer leur alignement ;
- chaque pilier P11, P12, P21, P22 peut être contraint par son propre actionneur ;
- les actionneurs A1, A2 ne sont pas nécessairement constitués de mâchoires, mais peuvent se présenter sous d'autres formes, notamment sous la forme d'un ressort similaire au ressort 46 schématisé sur la figure 1 ;
- Les premières extrémités L11, L21 des leviers L1, L2 peuvent directement agir sur les piliers piézoélectriques et jouer le rôle d'actionneur ;
- le galet GL12, GL22 peut constituer le moyen suiveur, auquel cas ce galet est directement monté roulant sur la surface de came SC ; une telle configuration correspond à celle schématisée sur la figure 1 ;
- Les bosses de la surface de came SC ainsi que les moyens suiveurs MS1, MS2 peuvent être remplacés par des aimants de manière à solliciter sans contact les leviers L1, L2.
- la mise en rotation de la came C pourrait directement être assurée par la source de puissance externe, en s'affranchissant de l'utilisation de la roue rotative R ; une telle configuration correspond à celle schématisée sur la figure 1 ;
- Une chaîne ou une courroie peut assurer l'accouplement entre la roue rotative R et les cames Ca, Cb.

## Revendications

1. Système pour produire une énergie électrique comportant au moins un premier ensemble générateur (EGa) comprenant :

   - au moins un premier générateur piézoélectrique (Ga) adapté pour générer une énergie électrique en réponse à une force mécanique appliquée sur ledit premier générateur,
   - un premier actionneur (Aa) adapté pour appliquer une force mécanique sur le premier générateur (Ga) lorsque ledit premier actionneur (Aa) est sollicité,
   - une première came rotative (Ca) présentant une surface de came (Sca),
   - un premier moyen suiveur (MSa) de la surface de came (SCa),
   - un premier levier (La) relié au premier moyen suiveur (MSa), lequel premier levier est monté en bras de levier et coopère avec le premier actionneur (Aa) pour le solliciter lorsque la première came (Ca) est entraînée en rotation et que la surface de came (SCa) exerce une force mécanique sur le premier moyen suiveur (MSa),

   **se caractérisant par le fait que** le système comporte au moins un second ensemble générateur (EGb) comprenant :

   - au moins un second générateur piézoélectrique (Gb) adapté pour générer une énergie électrique en réponse à une force mécanique appliquée sur ledit second générateur,

- un second actionneur (Ab) adapté pour appliquer une force mécanique sur le second générateur (EGb) lorsque ledit second actionneur est sollicité,
- une seconde came rotative (Cb) présentant une surface de came (SCb),
- un second moyen suiveur (MSb) de la surface de came (SCb),
- un second levier (Lb) relié au second moyen suiveur (MSb), lequel second levier est monté en bras de levier et coopère avec le second actionneur (Ab) pour le solliciter lorsque la seconde came (Cb) est entraînée en rotation et que la surface de came (SCb) exerce une force mécanique sur le second moyen suiveur (MSb), **et par le fait qu'**une roue rotative (R) est entraînée en rotation par une source de puissance, laquelle roue rotative est accouplée à la première came (Ca) et à la seconde came (Cb) de sorte que la mise en rotation de ladite roue rotative à une vitesse de rotation ($W_R$) entraîne la rotation desdites cames à une autre vitesse de rotation ($W_{Ca}$, $W_{Cb}$) qui est supérieure à celle de ladite roue rotative.

2. Système selon la revendication 1, **comportant** un nombre entier N≥2 d'ensembles générateurs (EGi) comprenant chacun :

   - au moins un générateur piézoélectrique adapté pour générer une énergie électrique en réponse à une force mécanique appliquée sur ledit générateur,
   - un actionneur adapté pour appliquer une force mécanique sur le générateur lorsque ledit actionneur est sollicité,
   - une came rotative présentant une surface de came,
   - un moyen suiveur de la surface de came,
   - un levier relié au moyen suiveur, lequel levier est monté en bras de levier et coopère avec l'actionneur pour le solliciter lorsque la came est entraînée en rotation et que la surface de came exerce une force mécanique sur ledit moyen suiveur,
   et dans lequel la roue rotative (R) est accouplée aux N cames de sorte que la mise en rotation de ladite roue rotative à une vitesse de rotation entraîne la rotation des N cames à une autre vitesse de rotation qui est supérieure à celle de ladite roue rotative.

3. Système selon la revendication 2, **dans lequel** les N cames sont décalées angulairement par rapport à l'axe de rotation (AR) de la roue rotative (R), ce décalage angulaire étant de $2\pi/N$.

4. Système selon l'une des revendications précédentes, **dans lequel :**

   - chaque ensemble générateur (EG) est associé à une came rotative (C) présentant une surface de came (SC), chaque dit ensemble générateur comprenant :

      o un premier sous-ensemble (SEG1) comportant: un générateur piézoélectrique (G1), un actionneur (A1), un moyen (MS1) suiveur de la surface de came (SC), un levier (L1),
      o un second sous-ensemble (SEG2) comportant : un autre générateur piézoélectrique (G2), un autre actionneur (A2), un autre moyen suiveur (MS2) de la surface de came (SC), un autre levier (L2),

   - le premier sous-ensemble (SEG1) et le second-sous-ensemble (SEG2) sont disposés symétriquement par rapport à l'axe de rotation (AC) de la came (C).

5. Système selon la revendication 4, dans lequel la surface de came (SC) est symétrique par rapport à l'axe de rotation (AC) de la came (C) de sorte que le moyen (MS1) suiveur de came du premier sous-ensemble (SEG1) et le moyen suiveur (MS2) de came du second sous-ensemble (SEG2), aient des mouvements analogues et synchronisés.

6. Système selon l'une des revendications précédentes, **dans lequel** chaque générateur piézoélectrique (G1, G2) se présente sous la forme de deux piliers piézoélectriques (P11-P12, P21-P22) formés chacun par l'alternance de céramiques piézoélectriques (2) et d'électrodes (3) empilées axialement, les deux piliers piézoélectriques (P11-P12, P21-P22) étant coaxiaux et disposés en opposition l'un par rapport à l'autre.

7. Système selon la revendication 6, **dans lequel** l'actionneur (A1, A2) se présente sous la forme d'une mâchoire agencée pour agir simultanément sur chacun des piliers piézoélectriques (P11-P12, P21-P22) lorsqu'elle est sollicitée par le levier (L1, L2).

8. Système selon l'une des revendications précédentes, **comportant** un nombre entier M≥2 d'ensembles générateurs ($EGi_1$-$EGi_M$) comprenant chacun :

   - au moins un générateur piézoélectrique adapté pour générer une énergie électrique en réponse à une force mécanique appliquée sur ledit générateur,
   - un actionneur adapté pour appliquer une force mécanique sur le générateur lorsque ledit actionneur est sollicité,

- une came rotative (Ci$_1$-Ci$_M$) présentant une surface de came,
- un moyen suiveur de la surface de came,
- un levier relié au moyen suiveur, lequel levier est monté en bras de levier et coopère avec l'actionneur pour le solliciter lorsque la came est entraînée en rotation et que la surface de came exerce une force mécanique sur ledit moyen suiveur,

**et dans lequel** les M cames (Ci$_1$-Ci$_M$) sont montées en parallèle sur un arbre de rotation commun (ACi), la roue rotative étant en prise avec cet axe de rotation commun de sorte que la mise en rotation dudit axe de rotation commun entraîne la mise en rotation simultanée desdites M cames.

9. Système selon la revendication 8, **dans lequel :**

- les M cames (Ci$_1$-Ci$_M$) présentent la même surface de came, laquelle surface de came est constituée d'une alternance régulière de creux et de bosses,
- les M cames (Ci$_1$-Ci$_M$) sont décalées angulairement sur l'axe de rotation commun (ACi), ce décalage angulaire étant de $2\pi/(M.B)$, où B correspond au nombre de bosses présentes sur la surface de came de chacune desdites cames.

10. Système selon la revendication 8, **dans lequel :**

- les M cames (Ci$_1$-Ci$_M$) présentent la même surface de came, laquelle surface de came est constituée d'une alternance régulière de creux et de bosses,
- les moyens suiveurs de la surface de came de chaque ensemble générateur (EGi$_1$-EGi$_M$) sont décalées angulairement sur l'axe de rotation commun (ACi), ce décalage angulaire étant de $2\pi/(M.B)$, où B correspond au nombre de bosses présentes sur la surface de came de chacune desdites cames.

11. Système selon l'une des revendications précédentes, dans lequel le moyen suiveur (MS1, MS2) comporte :

- une tige (MT1, MT2) adaptée pour exercer une force mécanique sur le levier (L1, L2) auquel elle est reliée, lequel levier, en réponse, sollicite l'actionneur correspondant (A1, A2),
- un galet (MG1, MG2), solidaire de la tige (MT1, MT2), monté roulant sur la surface de came (SC), lequel galet est agencé de sorte que lorsque la came (C) est entraînée en rotation et que ladite surface de came exerce une force mécanique sur ledit galet, la force mécanique exercée par ladite tige sur ledit levier (L1, L2) soit démultipliée.

12. Dispositif pour appliquer une force mécanique sur un générateur piézoélectrique (Ga, Gb) afin de générer une énergie électrique, lequel dispositif comporte :

- un actionneur (Aa, Ab) adapté pour appliquer une force mécanique sur le générateur (Ga, Gb) lorsque ledit actionneur est sollicité,
- une came rotative (Ca, Cb) présentant une surface de came (SCa, SCb),
- un moyen suiveur (MSa, MSb) de la surface de came (SCa, SCb),
- un levier (La, Lb) relié au moyen suiveur (MSa, MSb), lequel levier est monté en bras de levier et coopère avec l'actionneur (Aa, Ab) pour le solliciter lorsque la came (Ca, Cb) est entraînée en rotation et que la surface de came (SCa, SCb) exerce une force mécanique sur ledit moyen suiveur (MSa, MSb),

**se caractérisant par le fait qu'**une roue rotative (R) est adaptée pour être entraînée en rotation par une source de puissance, laquelle roue rotative est accouplée avec la came (Ca, Cb), de sorte que la mise en rotation de ladite roue rotative à une vitesse de rotation entraîne la rotation de ladite came à une autre vitesse de rotation qui est supérieure à celle de ladite roue rotative.

13. Procédé pour appliquer une force mécanique sur un générateur piézoélectrique (Ga, Gb) afin de générer une énergie électrique, ledit procédé comprenant les étapes consistant à :

- installer un actionneur (Aa, Ab) adapté pour appliquer une force mécanique sur le générateur (Ga, Gb) lorsque ledit actionneur est sollicité,
- installer une came rotative (Ca, Cb) présentant une surface de came (SCa, SCb),
- installer un moyen suiveur (MSa, MSb) de la surface de came (SCa, SCb),
- monter un levier (La, Lb) en bras de levier,
- relier le levier (La, Lb) au moyen suiveur (MSa, MSb), et faire coopérer ledit levier avec l'actionneur (Aa, Ab) de manière à ce que ledit levier soit en mesure de solliciter ledit actionneur et qu'en réponse à cette sollicitation, ledit actionneur applique une force mécanique sur le générateur (Ga, Gb),
- entraîner la came (Ca, Cb) en rotation de sorte que la surface de came (SCa, SCb) exerce une force mécanique sur le moyen suiveur (MSa, MSb) et que le levier (La, Lb) sollicite l'actionneur (Aa, Ab),

**se caractérisant par le fait que** le procédé comprend une étape consistant à accoupler la came (Ca, Cb) avec une roue rotative (R), de sorte que la mise en rotation de ladite roue rotative à une vitesse de rotation entraîne la rotation de ladite came à une autre vitesse de rotation qui est supérieure à celle de ladite roue rotative.

**Patentansprüche**

1. System zur Erzeugung elektrischer Energie, umfassend mindestens eine erste Generatoranordnung (EGa), umfassend:

   - mindestens einen ersten piezoelektrischen Generator (Ga), der geeignet ist, um elektrische Energie ansprechend auf eine mechanische Kraft zu erzeugen, die auf den ersten Generator ausgeübt wird,
   - einen ersten Betätiger (Aa), der geeignet ist, um eine mechanische Kraft auf den ersten Generator (Ga) auszuüben, wenn der erste Betätiger (Aa) betätigt wird,
   - einen ersten Drehnocken (Ca), der eine Nockenfläche (SCa) aufweist,
   - ein erstes Folgemittel (MSa) der Nockenfläche (SCa),
   - einen ersten Hebel (La), der mit dem ersten Folgemittel (MSa) verbunden ist, wobei der erste Hebel an dem Arm des Hebels montiert ist und mit dem ersten Betätiger (Aa) zusammenwirkt, um ihn zu betätigen, wenn der erste Nocken (Ca) in Drehung angetrieben wird, und wenn die Nockenfläche (SCa) eine mechanische Kraft auf das erste Folgemittel (MSa) ausübt,

   **dadurch gekennzeichnet, dass** das System mindestens eine zweite Generatoranordnung (EGb) umfasst, umfassend:

   - mindestens einen zweiten piezoelektrischen Generator (Gb), der geeignet ist, um elektrische Energie ansprechend auf eine mechanische Kraft zu erzeugen, die auf den zweiten Generator ausgeübt wird,
   - einen zweiten Betätiger (Ab), der geeignet ist, um eine mechanische Kraft auf den zweiten Generator (EGb) auszuüben, wenn der zweite Betätiger betätigt wird,
   - einen zweiten Drehnocken (Cb), der eine Nockenfläche (SCb) aufweist,
   - ein zweites Folgemittel (MSb) der Nockenfläche (SCb),
   - einen zweiten Hebel (Lb), der mit dem zweiten Folgemittel (MSb) verbunden ist, wobei der zweite Hebel an dem Arm des Hebels montiert ist und mit dem zweiten Betätiger (Ab) zusammenwirkt, um ihn zu betätigen, wenn der zweite Nocken (Cb) in Drehung angetrieben wird, und wenn die Nockenfläche (SCb) eine mechanische Kraft auf das zweite Folgemittel (MSb) ausübt,

   und dadurch, dass ein Drehrad (R) in Drehung von einer Leistungsquelle angetrieben wird, wobei das Drehrad mit dem ersten Nocken (Ca) und mit dem zweiten Nocken (Cb) derart gekoppelt ist, dass das Versetzen des Drehrads in Drehung mit einer Drehgeschwindigkeit ($W_R$) die Drehung der Nocken mit einer anderen Drehgeschwindigkeit ($W_{Ca}$, $W_{Cb}$) antreibt, die größer ist als jene des Drehrads.

2. System nach Anspruch 1, umfassend eine ganze Zahl $N \geq 2$ von Generatoranordnungen (EGi), jeweils umfassend:

   - mindestens einen piezoelektrischen Generator, der geeignet ist, um elektrische Energie ansprechend auf eine mechanische Kraft zu erzeugen, die auf den Generator ausgeübt wird,
   - einen Betätiger, der geeignet ist, um eine mechanische Kraft auf den Generator auszuüben, wenn der Betätiger betätigt wird,
   - einen Drehnocken, der eine Nockenfläche aufweist,
   - ein Folgemittel der Nockenfläche,
   - einen Hebel, der mit dem Folgemittel verbunden ist, wobei der Hebel an dem Arm des Hebels montiert ist und mit dem Betätiger zusammenwirkt, um ihn zu betätigen, wenn der Nocken in Drehung angetrieben wird, und wenn die Nockenfläche eine mechanische Kraft auf das Folgemittel ausübt,

   und dadurch, dass das Drehrad (R) mit N Nocken derart gekoppelt ist, dass das Versetzen des Drehrads in Drehung mit einer Drehgeschwindigkeit die Drehung der N Nocken mit einer anderen Drehgeschwindigkeit antreibt, die größer ist als jene des Drehrads.

3. System nach Anspruch 2, wobei die N Nocken winkelmäßig in Bezug auf die Drehachse (AR) des Drehrads (R) versetzt sind, wobei diese winkelmäßige Versetzung 2 n/N beträgt.

4. System nach einem der vorhergehenden Ansprüche, wobei:

   - jede Generatoranordnung (EG) mit einem Drehnocken (C) assoziiert ist, der eine Nockenfläche (SC) aufweist, wobei jede Generatoranordnung umfasst:

o eine erste Unteranordnung (SEG1), umfassend: einen piezoelektrischen Generator (G1), einen Betätiger (A1), ein Folgemittel (MS1) der Nockenfläche (SC), einen Hebel (L1),

o eine zweite Unteranordnung (SEG2), umfassend: einen weiteren piezoelektrischen Generator (G2), einen weiteren Betätiger (A2), ein weiteres Folgemittel (MS2) der Nockenfläche (SC), einen weiteren Hebel (L2),

- wobei die erste Unteranordnung (SEG1) und die zweite Unteranordnung (SEG2) symmetrisch in Bezug auf die Drehachse (AC) des Nockens (C) angeordnet sind.

5. System nach Anspruch 4, wobei die Nockenfläche (SC) derart symmetrisch in Bezug auf die Drehachse (AC) des Nockens (C) ist, dass das Nockenfolgemittel (MS1) der ersten Unteranordnung (SEG1) und das Nockenfolgemittel (MS2) der zweiten Unteranordnung (SEG2) analoge und synchronisierte Bewegungen aufweisen.

6. System nach einem der vorhergehenden Ansprüche, wobei jeder piezoelektrische Generator (G1, G2) in der Form von zwei piezoelektrischen Säulen (P11-P12, P21-P22) dargestellt ist, welche jeweils durch das Abwechseln von piezoelektrischen Keramiken (2) und von Elektroden (3) gebildet sind, die axial gestapelt sind, wobei die beiden piezoelektrischen Säulen (P11-P12, P21-P22) koaxial sind und einander gegenüber angeordnet sind.

7. System nach Anspruch 6, wobei der Betätiger (A1, A2) in der Form einer Backe dargestellt ist, die eingerichtet ist, um gleichzeitig auf jede der piezoelektrischen Säulen (P11-P12, P21-P22) zu wirken, wenn sie von dem Hebel (L1, L2) betätigt wird.

8. System nach einem der vorhergehenden Ansprüche, umfassend eine ganze Zahl $M \geq 2$ von Generatoranordnungen ($EGi_1$-$EGi_M$), jeweils umfassend:

- mindestens einen piezoelektrischen Generator, der geeignet ist, um elektrische Energie ansprechend auf eine mechanische Kraft zu erzeugen, die auf den Generator ausgeübt wird,
- einen Betätiger, der geeignet ist, um eine mechanische Kraft auf den Generator auszuüben, wenn der Betätiger betätigt wird,
- einen Drehnocken ($Ci_1$-$Ci_M$), der eine Nockenfläche aufweist,
- ein Folgemittel der Nockenfläche,
- einen Hebel, der mit dem Folgemittel verbunden ist, wobei der Hebel an dem Arm des Hebels montiert ist und mit dem Betätiger zusammenwirkt, um ihn zu betätigen, wenn der Nocken in Drehung angetrieben wird, und wenn die Nockenfläche eine mechanische Kraft auf das Folgemittel ausübt,

und wobei die M Nocken ($Ci_1$-$Ci_M$) parallel an einer gemeinsamen Drehwelle (ACi) montiert sind, wobei das Drehrad mit dieser gemeinsamen Drehachse derart in Eingriff steht, dass das Versetzen der gemeinsamen Drehachse in Drehung das gleichzeitige Versetzen der M Nocken in Drehung antreibt.

9. System nach Anspruch 8, wobei:

- die M Nocken ($Ci_1$-$Ci_M$) dieselbe Nockenfläche aufweisen, wobei die Nockenfläche aus einem regelmäßigen Abwechseln von Vertiefungen und von Erhebungen besteht,
- die M Nocken ($Ci_1$-$Ci_M$) winkelmäßig auf der gemeinsamen Drehachse (ACi) versetzt sind, wobei diese winkelmäßige Versetzung $2 n/(M.B)$ beträgt, wobei B der Anzahl von Erhebungen entspricht, die auf der Nockenfläche jedes der Nocken vorhanden sind.

10. System nach Anspruch 8, wobei:

- die M Nocken ($Ci_1$-$Ci_M$) dieselbe Nockenfläche aufweisen, wobei die Nockenfläche aus einem regelmäßigen Abwechseln von Vertiefungen und von Erhebungen besteht,
- die Folgemittel der Nockenfläche jeder Generatoranordnung ($EGi_1$-$EGi_M$) winkelmäßig auf der gemeinsamen Drehachse (ACi) versetzt sind, wobei diese winkelmäßige Versetzung $2 n/(M.B)$ beträgt, wobei B der Anzahl von Erhebungen entspricht, die auf der Nockenfläche jedes der Nocken vorhanden sind.

11. System nach einem der vorhergehenden Ansprüche, wobei das Folgemittel (MS1, MS2) umfasst:

- einen Schaft (MT1, MT2), der geeignet ist, um eine mechanische Kraft auf den Hebel (L1, L2) auszuüben, mit dem er verbunden ist, wobei der Hebel, ansprechend darauf, den entsprechenden Betätiger (A1, A2) betätigt,
- einen Stößel (MG1, MG2), der mit dem Schaft (MT1, MT2) fest verbunden ist, und der rollend auf der Nockenfläche (SC) montiert ist, wobei der Stößel derart eingerichtet ist, dass, wenn der Nocken (C) in Drehung angetrieben wird, und wenn die Nockenfläche eine mechanische Kraft auf den Stößel ausübt, die mechanische Kraft, die von dem Schaft auf den Hebel (L1, L2) ausgeübt wird, untersetzt wird.

**12.** Vorrichtung zum Ausüben einer mechanischen Kraft auf einen piezoelektrischen Generator (Ga, Gb), um elektrische Energie zu erzeugen, wobei die Vorrichtung umfasst:

- einen Betätiger (Aa, Ab), der geeignet ist, um eine mechanische Kraft auf den Generator (Ga, Gb) auszuüben, wenn der Betätiger betätigt wird,
- einen Drehnocken (Ca, Cb), der eine Nockenfläche (SCa, SCb) aufweist,
- ein Folgemittel (MSa, MSb) der Nockenfläche (SCa, SCb),
- einen Hebel (La, Lb), der mit dem Folgemittel (MSa, MSb) verbunden ist, wobei der Hebel an dem Arm des Hebels montiert ist und mit dem Betätiger (Aa, Ab) zusammenwirkt, um ihn zu betätigen, wenn der Nocken (Ca, Cb) in Drehung angetrieben wird, und wenn die Nockenfläche (SCa, SCb) eine mechanische Kraft auf das Folgemittel (MSa, MSb) ausübt,

**dadurch gekennzeichnet, dass** ein Drehrad (R) geeignet ist, in Drehung von einer Leistungsquelle angetrieben zu werden, wobei das Drehrad mit dem Nocken (Ca, Cb) derart gekoppelt ist, dass das Versetzen des Drehrads in Drehung mit einer Drehgeschwindigkeit die Drehung des Nockens mit einer anderen Drehgeschwindigkeit antreibt, die größer ist als jene des Drehrads.

**13.** Verfahren zum Ausüben einer mechanischen Kraft auf einen piezoelektrischen Generator (Ga, Gb), um elektrische Energie zu erzeugen, wobei das Verfahren die Schritte umfasst, die bestehen aus:

- Installieren eines Betätigers (Aa, Ab), der geeignet ist, um eine mechanische Kraft auf den Generator (Ga, Gb) auszuüben, wenn der Betätiger betätigt wird,
- Installieren eines Drehnockens (Ca, Cb), der eine Nockenfläche (SCa, SCb) aufweist,
- Installieren eines Folgemittels (MSa, MSb) der Nockenfläche (SCa, SCb),
- Montieren eines Hebels (La, Lb) an dem Arm des Hebels,
- Verbinden des Hebels (La, Lb) mit dem Folgemittel (MSa, MSb) und Zusammenwirkenlassen des Hebels mit dem Betätiger (Aa, Ab) derart, dass der Hebel in der Lage ist, den Betätiger zu betätigen, und dass ansprechend auf diese Betätigung der Betätiger eine mechanische Kraft auf den Generator (Ga, Gb) ausübt,
- Antreiben des Nockens (Ca, Cb) in Drehung derart, dass die Nockenfläche (SCa, SCb) eine mechanische Kraft auf das Folgemittel (MSa, MSb) ausübt, und dass der Hebel (La, Lb) den Betätiger (Aa, Ab) betätigt,

**dadurch gekennzeichnet, dass** das Verfahren einen Schritt umfasst, der aus dem Koppeln des Nockens (Ca, Cb) mit einem Drehrad (R) derart, dass das Versetzen des Drehrads in Drehung mit einer Drehgeschwindigkeit die Drehung des Nockens mit einer anderen Drehgeschwindigkeit antreibt, die größer ist als jene des Drehrads, besteht.

**Claims**

**1.** System for producing electrical energy including at least one first generator assembly (EGa) comprising:

- at least one first piezoelectric generator (Ga) suitable for generating electrical energy in response to a mechanical force applied to said first generator,
- a first actuator (Aa) suitable for applying a mechanical force to the first generator (Ga) when said first actuator (Aa) is actuated,
- a first rotary cam (Ca) having a cam surface (Sca),
- a first follower (MSa) of the cam surface (SCa),
- a first lever (La) connected to the first follower (MSa), which first lever is mounted as a lever-arm and interacts with the first actuator (Aa) in order to actuate it when the first cam (Ca) is driven to rotate and the cam surface (SCa) exerts a mechanical force on the first follower (MSa),

**characterized in that** the system includes at least one second generator assembly (EGb) comprising:

- at least one second piezoelectric generator (Gb) suitable for generating electrical energy in response to a mechanical force applied to said second generator,
- a second actuator (Ab) suitable for applying a mechanical force to the second generator (EGb) when said second actuator is actuated,
- a second rotary cam (Cb) having a cam surface (SCb),
- a second follower (MSb) of the cam surface (SCb),
- a second lever (Lb) connected to the second follower (MSb), which second lever is mounted as a lever-arm and interacts with the second actuator (Ab) in order to actuate it when the second cam (Cb) is driven to rotate and the cam surface (SCb) exerts a mechanical force on the second follower (MSb),

**and in that** a rotary wheel (R) is driven to rotate by a power source, which rotary wheel is coupled to the first cam (Ca) and to the second cam (Cb) so that the rotation of said rotary wheel at a rotation speed ($W_R$) drives said cams to rotate at another rotation speed ($W_{Ca}$, $W_{Cb}$) that is higher than that of said rotary wheel.

2. System according to Claim 1, including an integer number $N \geq 2$ of generator assemblies (EGi) each comprising:

- at least one piezoelectric generator suitable for generating electrical energy in response to a mechanical force applied to said generator,
- an actuator suitable for applying a mechanical force to the generator when said actuator is actuated,
- a rotary cam having a cam surface,
- a follower of the cam surface,
- a lever connected to the follower, which lever is mounted as a lever-arm and interacts with the actuator in order to actuate it when the cam is driven to rotate and the cam surface exerts a mechanical force on said follower,
**and wherein** the rotary wheel (R) is coupled to the N cams so that the rotation of said rotary wheel at a rotation speed drives the N cams to rotate at another rotation speed that is higher than that of said rotary wheel.

3. System according to Claim 2, **wherein** the N cams are angularly offset with respect to the axle (AR) of the rotary wheel (R), this angular offset being of $2\pi/N$.

4. System according to one of the preceding claims, **wherein:**

- each generator assembly (EG) is associated with a rotary cam (C) having a cam surface (SC), each said generator assembly comprising:

o a first subassembly (SEG1) including: a piezoelectric generator (G1), an actuator (A1), a follower (MS1) of the cam surface (SC), a lever (L1),
o a second subassembly (SEG2) including: another piezoelectric generator (G2), another actuator (A2), another follower (MS2) of the cam surface (SC), another lever (L2),

- the first subassembly (SEG1) and the second subassembly (SEG2) are placed symmetrically with respect to the axle (AC) of the cam (C).

5. System according to Claim 4, **wherein** the cam surface (SC) is symmetric with respect to the axle (AC) of the cam (C) so that the cam follower (MS1) of the first subassembly (SEG1) and the cam follower (MS2) of the second subassembly (SEG2) have analogue and synchronized movements.

6. System according to one of the preceding claims, **wherein** each piezoelectric generator (G1, G2) takes the form of two piezoelectric pillars (P11-P12, P21-P22) each formed by an alternation of axially stacked piezoelectric ceramics (2) and electrodes (3), the two piezoelectric pillars (P11-P12, P21-P22) being coaxial and placed opposite each other.

7. System according to Claim 6, **wherein** the actuator (A1, A2) takes the form of a jaw arranged to act simultaneously on each of the piezoelectric pillars (P11-P12, P21-P22) when it is actuated by the lever (L1, L2).

8. System according to one of the preceding claims, **including** an integer number $M \geq 2$ of generator assemblies ($EGi_1$-$EGi_M$) each comprising:

- at least one piezoelectric generator suitable for generating electrical energy in response to a mechanical force applied to said generator,
- an actuator suitable for applying a mechanical force to the generator when said actuator is actuated,
- a rotary cam ($Ci_1$-$Ci_M$) having a cam surface,
- a follower of the cam surface,
- a lever connected to the follower, which lever is mounted as a lever-arm and interacts with the actuator in order to actuate it when the cam is driven to rotate and the cam surface exerts a mechanical force on said follower,
**and wherein** the M cams ($Ci_1$-$Ci_M$) are mounted in parallel on a common axle (ACi), the rotary wheel being engaged with this common axle so that rotating said common axle drives said M cams to rotate simultaneously.

9. System according to Claim 8, **wherein:**

- the M cams ($Ci_1$-$Ci_M$) have the same cam surface, which cam surface is made up of a regular alternation of dips and bumps,
- the M cams ($Ci_1$-$Ci_M$) are angularly offset about the common axle (ACi), this angular offset being of $2\pi/(M.B)$, where B corresponds to the number of bumps present on the cam surface of each of said cams.

10. System according to Claim 8, **wherein:**

- the M cams ($Ci_1$-$Ci_M$) have the same cam surface, which cam surface is made up of a regular alternation of dips and bumps,
- the followers of the cam surface of each generator assembly ($EGi_1$-$EGi_M$) are angularly offset about the common axle (ACi), this angular offset being of $2\pi/(M.B)$, where B corresponds to the number of bumps present on the cam surface of each of said cams.

**11.** System according to one of the preceding claims, **wherein** the follower (MS1, MS2) includes:

- a shaft (MT1, MT2) suitable for exerting a mechanical force on the lever (L1, L2) to which it is connected, which lever, in response, actuates the corresponding actuator (A1, A2),
- a roller (MG1, MG2) that is securely fastened to the shaft (MT1, MT2) and mounted so as to roll over the cam surface (SC), which roller is arranged so that when the cam (C) is driven to rotate and said cam surface exerts a mechanical force on said roller, the mechanical force exerted by said shaft on said lever (L1, L2) is reduced.

**12.** Device for applying a mechanical force to a piezoelectric generator (Ga, Gb) in order to generate electrical energy, which device includes:

- an actuator (Aa, Ab) suitable for applying a mechanical force to the generator (Ga, Gb) when said actuator is actuated,
- a rotary cam (Ca, Cb) having a cam surface (SCa, SCb),
- a follower (MSa, MSb) of the cam surface (SCa, SCb),
- a lever (La, Lb) connected to the follower (MSa, MSb), which lever is mounted as a lever-arm and interacts with the actuator (Aa, Ab) in order to actuate it when the cam (Ca, Cb) is driven to rotate and the cam surface (SCa, SCb) exerts a mechanical force on said follower (MSa, MSb), **characterized in that** a rotary wheel (R) is suitable for being driven to rotate by a power source, which rotary wheel is coupled to the cam (Ca, Cb), so that rotation of said rotary wheel at a rotation speed drives said cam to rotate at another rotation speed that is higher than that of said rotary wheel.

**13.** Method for applying a mechanical force to a piezoelectric generator (Ga, Gb) in order to generate electrical energy, said method comprising the steps consisting in:

- installing an actuator (Aa, Ab) suitable for applying a mechanical force to the generator (Ga, Gb) when said actuator is actuated,
- installing a rotary cam (Ca, Cb) having a cam surface (SCa, SCb),
- installing a follower (MSa, MSb) of the cam surface (SCa, SCb),
- mounting a lever (La, Lb) as a lever-arm,
- connecting the lever (La, Lb) to the follower (MSa, MSb), and making said lever interact with the actuator (Aa, Ab) so that said lever is able to actuate said actuator and, in response to this actuation, said actuator applies a mechanical force to the generator (Ga, Gb),
- driving the cam (Ca, Cb) to rotate so that the cam surface (SCa, SCb) exerts a mechanical force on the follower (MSa, MSb) and the lever (La, Lb) actuates the actuator (Aa, Ab), **characterized in that** the method comprises a step consisting in coupling the cam (Ca, Cb) to a rotary wheel (R), so that rotating said rotary wheel at a rotation speed drives said cam to rotate at another rotation speed that is higher than that of said rotary wheel.

**Fig. 1**

(art antérieur)

**Fig. 2**

**Fig. 3**

**Fig. 4**

**Fig. 5**

**Fig. 6**

Fig. 7

R

EGiM

CiM

ACi
Ei

EGi1

Ci1

# Fig. 8

**Fig. 9**

CO2

CO1

EGi

AR

R

Fig. 10

Fig. 11

**Fig. 12**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7005779 B

- GB 2106330 A